# EUROPÄISCHE PATENTANMELDUNG

(11) **EP 2 020 748 A2**
(43) Veröffentlichungstag der Anmeldung: **04.02.2009**
(21) Anmeldenummer: 08012364.9
(22) Anmeldetag: 09.07.2008
(51) Int. Cl.: H03K 17/0812, H03K 17/06, H03K 17/16

(54) **Aktive Clampingschaltung für einen Leistungshalbleiterschalter**

(30) Priorität: 03.08.2007 DE 102007036727
(71) Anmelder: SEMIKRON Elektronik GmbH & Co. KG, 90431 Nürnberg (DE)
(72) Erfinder: Mühlhöfer, Alexander, 90522 Oberasbach (DE); Königsmann, Gunther, 91058 Erlangen-Tennenlohe (DE); Hofmair, Markus, 91154 Roth (DE); Obernöder, Daniel, 97346 Iphofen (DE)

(57) **Zusammenfassung**

Eine Clampingschaltung (10) für einen auf ein Bezugspotential (GND) bezogenen Schalteingang (8) eines Leistungshalbleiterschalters (2), enthält einen mit dem Schalteingang (8) verbindbaren Knoten (16) und ein vom Knoten (16) zum Bezugspotential (GND) führendes Widerstandselement (11) mit einem Aktivierungseingang (12), das im nicht aktivierten Zustand einen ersten Widerstandswert (R_{GE1}) aufweist und im aktivierten Zustand einen zweiten, höheren Widerstandswert (R_{GE2}) aufweist.

## Beschreibung

Die Erfindung betrifft eine aktive Clampingschaltung für einen auf ein Bezugspotential bezogenen Schalteingang eines Leistungshalbleiterschalters.

Ein Leistungshalbleiterschalter, z.B. ein IGBT, dient zum Schalten großer Spannungen und Ströme. Um den eigentlichen Schaltvorgang auszulösen, wird der Leistungshalbleiterschalter an seinem Schalteingang durch ein Steuersignal angesteuert. Dieses wird von einer Treiberschaltung - kurz Treiber - generiert. Fällt das Steuersignal des Treibers aus, z.B. wenn dieser nicht mit Energie versorgt wird, kann in ungünstigen Fällen der Schaltzustand des Leistungshalbleiterschalters undefiniert sein.

Undefiniert heißt, dass dann nicht sichergestellt ist, ob der IGBT ein- oder ausschaltet bzw. im derzeitigen Schaltzustand verbleibt. Ein ungewolltes Schalten des IGBT passiert z.B. dann, wenn sich der mit dem Gate des IGBT verbundene Schalteingang über eine parasitäre Kapazität des Leistungshalbleiterschalters, im Falle des IGBT z.B. die Miller-Kapazität zwischen Kollektor und Gate, auflädt. Eine derartige Aufladung passiert z.B. wenn sich die Spannung am Kollektor des IBGT durch eine externe Spannungsquelle zeitlich ändert. Dies wiederum kann z.B. geschehen durch parallel geschaltete IGBTs, welche die Zwischenkreisspannung in einer z.B. Stromrichterschaltung schalten.

Eine derartige Situation ist in jedem Fall zu vermeiden. Um ungewolltes Schalten zu verhindern ist es bekannt, den Schalteingang durch einen ohmschen Widerstand bzw. Schutzwiderstand mit dem Bezugspotential des Halbleiterschalters, z.B. Masse, zu verbinden. Eine derartige Schutzbeschaltung des Schalteingangs eines Leistungshalbleiterschalters wird auch passive Clampingschaltung genannt. Der Widerstand der Clampingschaltung darf nicht zu groß sein, damit auch bei großen Spannungsschwankungen dU/dt zwischen Kollektor und Emitter eines IGBT ein Einschalten des IGBT verhindert wird.

Nachteilig hierbei ist, dass, je niedriger der Widerstandwert ist, die durch ihn verursachte Verlustleistung im Normalbetrieb des IGBT ansteigt. Im Normalbetrieb liegt gegenüber dem Bezugspotential Spannung am Schalteingang, welche über den Schutzwiderstand einen Stromfluss und damit eine Verlustleistung erzeugt. Eine Verkleinerung des Widerstandswertes des Schutzwiederstandes ist daher nur bis zu einem bestimmten Maß, je nach Anwendung, wirtschaftlich möglich.

Aufgabe der vorliegenden Erfindung ist es, eine verbesserte Clampingschaltung für den Schalteingang eines Leistungshalbleiterschalters vorzuschlagen.

Die Aufgabe wird gelöst durch eine aktive Clampingschaltung für einen Schalteingang eines Halbleiterschalters, wobei der Schalteingang auf ein Bezugspotential bezogen ist. Ein derartiges Bezugspotential ist in der Regel Masse. Die aktive Clampingschaltung weist einen mit dem Schalteingang verbindbaren Knoten und ein vom Knoten zum Bezugspotential führendes Widerstandselement auf. Die Clampingschaltung weist außerdem einen Aktivierungseingang auf. Durch den Aktivierungseingang ist die Clampingschaltung in einen aktivierten oder in einen nicht aktivierten Zustand schaltbar und daher eine aktive Schaltung. Im nichtaktivierten Zustand weist das Widerstandselement einen ersten Widerstandwert auf. Im aktivierten Zustand weist das Widerstandselemente einen zweiten Widerstandwert auf, der höher ist als der erste Widerstandswert.

Die Clampingschaltung ist damit im nichtaktivierten Zustand, wenn sie z.B. stromlos ist, niederohmig zum Bezugspotential hin. Durch Aktivierung, die in der Regel im Normalbetrieb des Halbleiterschalters erfolgt, d.h. bei Bereitstellung eines Schaltsignals vom Treiber, wird die Clampingschaltung zwischen Schalteingang und Bezugspotential hochohmig geschaltet.

Somit ergibt sich bei nichtaktivem Zustand der Vorteil, dass der Schalteingang des Halbleiterschalters niederohmig zum Bezugspotential geführt ist, was einen sicheren und dauerhaften Schaltzustand des Halbleiterschalters garantiert. Im Betrieb des Halbleiterschalters kann die Clampingschaltung hochohmig geschaltet werden, um einen Stromfluss vom Schalteingang zum Bezugspotential und die damit verknüpfte Verlustleistung drastisch zu reduzieren.

Das Widerstandselement kann einen am Knoten angeschlossenen und zum Bezugspotential führenden ohmschen Widerstand im Bereich des zweiten Widerstandwertes aufweisen. Die Clampingschaltung enthält dann zusätzlich eine Bypassschaltung für den Widerstand, welche im nicht aktivierten Zustand des Widerstandselements leitend ist und im aktivierten Zustand gesperrt ist. Im aktivierten Zustand, wenn also die Bypassschaltung gesperrt ist, bildet lediglich der ohmsche Widerstand eine Verbindung vom Knoten zum Bezugspotential. Die Clampingschaltung weist damit den zweiten Widerstandswert auf. Im nicht aktivierten Zustand ist die Bypassschaltung leitend, überbrückt damit den ersten Widerstand und bildet durch ihren Eigenwiderstand in etwa den ersten, niedrigeren Widerstandswert, welcher damit vom Knoten zum Bezugspotential führt.

Die Bypassschaltung kann mindestens einen ersten Transistor enthalten, welcher mit seinem Kollektor am Knoten und mit seiner Basis am dem Knoten abgewandten Ende des Widerstands angeschlossen ist. Der Emitter des Transistors führt zum Bezugspotential. Die Bypassschaltung enthält dann auch einen vom Widerstand bzw. der Basis des ersten Transistors zum Bezugspotential führenden Schalter.

Durch die Aufnahme des Transistors und des Schalters entsteht eine Clampingschaltung, welche im Falle eines leerlaufenden Schalteingangs niederohmig zum Bezugspotential ist und durch Schließen des Schalters zwischen Schalteingang und Bezugspotential hochohmig geschaltet werden kann. Ist nämlich der Schalter geöffnet, so entsteht bei Anliegen einer Spannung bzw. Ladung am Schalteingang bezüglich des Bezugspotentials durch das selbstschaltende Verhalten des Transistors über dessen Kollektor und Emitter eine niederohmige Verbindung zum Bezugspotential, die den ersten Widerstandswert aufweist. Wird dagegen der Schalter geschlossen, liegt die Basis des Transistors auf dem Bezugspotential, der Transistor sperrt und ein Stromfluss vom Schalteingang ist nur über den Widerstand möglich. Der Widerstand wird hierbei hochohmig, also im Bereich des zweiten Widerstandswertes, dimensioniert.

Der Schalter kann einen zweiten Transistor enthalten. Der Schalter ist dann ebenfalls in Halbleiterform ausgeführt, mechanische Bauelemente werden vermieden, die gesamte Clampingschaltung wird dadurch rein elektronisch.

Der erste Transistor kann auch Teil einer Transistorkaskade nach Art eines Darlingtontransistors sein. Somit sind in der Clampingschaltung mehrere erste Transistoren vorhanden, welche die je nach Schaltzustand des Schalters niederohmige oder hochohmige Verbindung zwischen Schalteingang und Bezugspotential herstellen. Eine Transistoranordnung nach Art eines Darlingtontransistors besitzt eine sehr hohe Verstärkung wodurch der Widerstand, also der Schutzwiderstand, größer gewählt werden kann und sich hierdurch im Normalbetrieb geringere Verluste ergeben.

In einem derartigen Fall kann dann jedem Transistor der Transistorkaskade ein eigener Schalter zugeordnet sein, wobei sämtliche Schalter gleichschaltend sind. Auch in diesem Fall können die Schalter natürlich wieder selbst Transistoren enthalten.

Dem Widerstand kann ein Kondensator parallel geschaltet sein. Der Kondensator wirkt dann als Beschleunigungskondensator und verstärkt bei einer schnellen Änderung der Spannung am Schalteingang den Strom in die Basis des bzw. der ersten Transistoren.

Der Knoten kann mit dem Eingang über eine Diode verbindbar sein. Eine normalerweise gegenüber dem Bezugspotential positive Einschaltspannung vorausgesetzt, entkoppelt die Diode damit den Clampingschaltkreis vom Schalteingang, so dass keine negative Spannung bei ausgeschaltetem Leistungshalbleiterschalter, insbesondere bei ausgeschaltetem IGBT (negative Spannung gegenüber dem Bezugspotential) an der Basis des ersten Transistors anliegt.

Für eine weitere Beschreibung der Erfindung wird auf die Ausführungsbeispiele der Zeichnungen verwiesen. Es zeigen, jeweils in einer schematischen Prinzipskizze:
- Fig. 1: ein Prinzipbild einer erfindungsgemäßen Clampingschaltung,
- Fig. 2: eine Ausführungsform der Clampingschaltung mit zwei einfachen Transistoren,
- Fig. 3: eine Ausführungsform der Clampingschaltung mit Darlingtonschaltung und doppelter Transistoransteuerung.

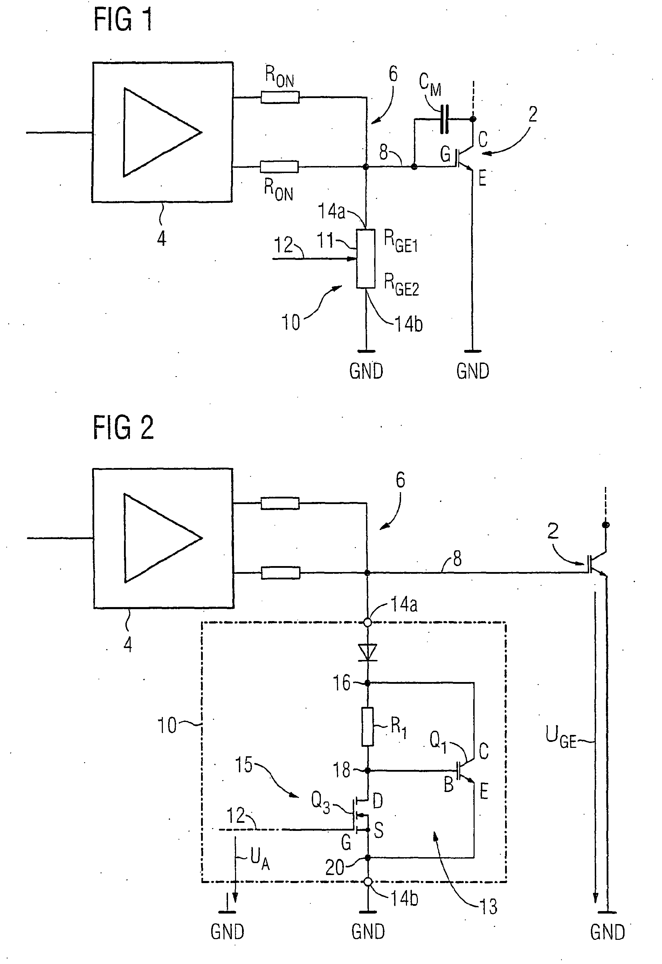

Fig. 1 zeigt als Halbleiterschalter einen IGBT 2, welcher von einem Treiber 4 angesteuert wird, um diesen ein- und auszuschalten. Der Treiber 4 weist hierzu einen Ausgang 6 auf, welcher am Eingang 8 des IGBT 2 angeschlossen ist. Am Eingang 8 ist außerdem eine aktive Clampingschaltung 10 angeschlossen, welche zur Masse GND führt, die ebenfalls das Bezugspotential für den IGBT 2 darstellt. Dieser wird nämlich über seinen Eingang 8 bezüglich dieses Bezugspotentials ein- oder ausgeschaltet.

Am IGBT 2 ist dessen parasitäre Millerkapazität C_{M} dargestellt, welche sich zwischen Gate G und Kollektor C befindet. Ist der Treiber 4 inaktiv, z.B. nicht mit Energie versorgt bzw. ist dessen Ausgang 6 hochohmig, hat er keinerlei treibende Wirkung auf den Eingang 8. Ein über die Millerkapazität C_{M} fließender Strom führt daher zur Aufladung des Gate G bzw. Eingangs 8 und eventuell zum ungewollten Schalten des IGBT 2, wenn nicht die Clampingschaltung 10 vorhanden wäre, über welche eine derartige Ladung am Gate G zur Masse GND abfließen kann.

Die Clampingschaltung 10 enthält ein Widerstandselement 11 und besitzt zwei Betriebszustände, welche über einen Aktivierungseingang 12 schaltbar sind. Im inaktiven Zustand besitzt die Clampingschaltung 10 bzw. das Widerstandselement 11 einen ersten ohmschen Widerstand R_{GE1}, welcher derart niederohmig ist, dass eine sich am Gate G ansammelnde Ladung gegen Masse GND abfließen kann.

Ist der Treiber 4 jedoch aktiv, d.h. erzeugt dieser ein Potential am Gate G, so würde durch die Potentialdifferenz zwischen Eingang 8 und Masse GND ein hoher Strom über den niederohmigen Widerstand R_{GE1} fließen. Für einen derartigen Fall ist daher durch den Aktivierungseingang 12 die Clampingschaltung 10 aktivierbar, d.h. sie bzw. das Widerstandselement 11 nimmt den deutlich erhöhten ohmschen Widerstand R_{GE2} an. Vom Gate G fließt daher durch die Clampingschaltung 10 deutlich weniger Strom zur Masse GND, was zu einer deutlich reduzierten Verlustleistung der Schaltung in Fig. 1 führt.

Fig. 2 zeigt eine Ausführungsform der Clampingschaltung 10 zwischen deren Anschlussklemmen 14a und b. Am Eingang 14a ist zunächst eine Diode D1 angeschlossen, welche über einen Knoten 16, einen Widerstand R1 und einen Knoten 18 auf den Drainanschluss D einen Feldeffekttransistors Q3 führt. Die Source S des Transistors Q3 führt über einen weiteren Knoten 20 zur Anschlussklemme 14b. Das Gate G des Transistors Q3 ist mit dem Aktivierungseingang 12 verbunden, bzw. stellt diesen dar. Ein Bipolartransistor Q1 ist mit seinem Kollektor C am Knoten 16, mit seiner Basis B am Knoten 18 und mit seinem Emitter E am Knoten 20 angeschlossen. Die Transistoren Q1 und Q3 bilden so eine durch den Aktivierungseingang 12 aktivierbare Bypassschaltung 13 für den Widerstand R1.

Der Transistor Q3 bildet einen Schalter 15 und könnte in einer alternativen Ausführungsform auch durch einen mechanischen Schalter 15 ausgeführt sein, der die Knoten 18 und 20 auf einen Schaltbefehl am Aktivierungseingang 12 verbindet.

Ist die Clampingschaltung 10 nicht aktiviert, d.h. ist die Aktivierungsspannung U_{A} am Aktivierungseingang 12 gleich 0V, ist der Transistor Q3 ausgeschaltet. Dieser sperrt und bildet somit zwischen den Knoten 18 und 20 einen Leerlauf. Im Falle einer Ladung auf dem Gate G bzw. Eingang 8 fließt daher ein Strom durch die Anschlussklemme 14a über die Diode D1 und den Widerstand R1 auf die Basis B des Transistors Q1 und macht diesen leitend. Der Transistor Q1 wird zwischen Kollektor C und Emitter E niederohmig und führt die Ladung bzw. Spannung am Eingang 8 zum Knoten 20 und damit zur Masse GND hin ab. Der Durchgangswiderstand der Clampingschaltung 10 ist in diesem Fall R_{GE1}, dargestellt durch den Kollektor-Emitterwiderstand des Transistors Q1.

Bei Anlegen der Aktivierungsspannung UA am Aktivierungseingang 12 wird der Transistor Q3 leitend und bildet eine niederohmige Verbindung zwischen den Knoten 18 und 20. Dadurch wird die Basis des Transistors Q1 auf Massepotential GND gezogen, der Transistor Q1 sperrt, und vom Eingang 8 besteht lediglich noch eine leitende Verbindung über die Diode D1 und den Widertand R1 zur Masse GND. Der Widerstand R1 ist dabei hochohmig, und entspricht in etwa dem Wert R_{GE2} der Clampingschaltung 10 zwischen den Anschlussklemmen 14a,b. Mit anderen Worten deaktiviert die Aktivierungsspannung UA den Stromweg über den Transistor Q1.

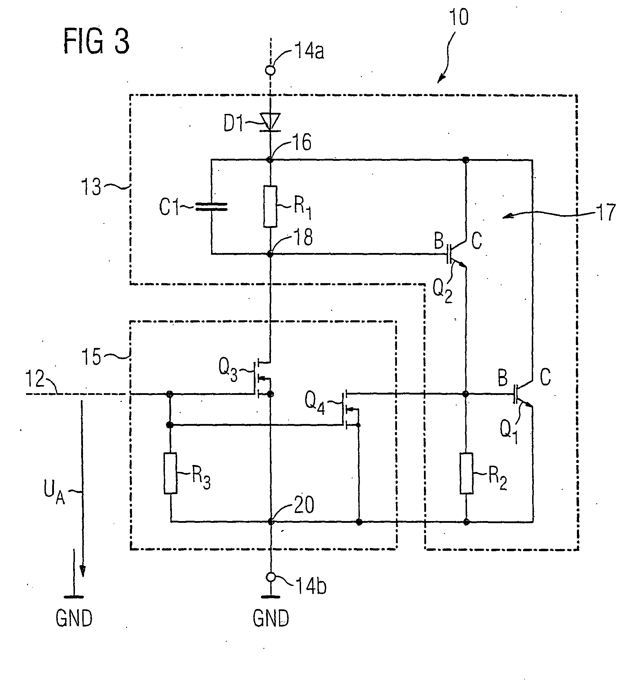

Fig. 3 zeigt eine alternative Ausführungsform einer Clampingschaltung 10. Die Schaltung besteht aus einem ClampingSchaltkreis bzw. Bypassschaltung 15, der aus den Transistoren Q1, Q2, den Widerständen R1, R2 und der Kapazität C1 aufgebaut ist. Hier entspricht die Kombination aus Q1 und Q2 der eines Darlington-Transistors mit sehr hoher Verstärkung. Der Schaltkreis zur Aktivierung und Deaktivierung des Gate-Clamping, also der Schalter 15, besteht aus den Transistoren Q3, Q4 und dem Widerstand R3. Die Transistoren Q3 und Q4 bilden eine Transistordekade 17 nach Art eines Darlington-Transistors.

Wird der Treiber 4 z.B. nicht mit Spannung versorgt, hat der ansteuernde Schaltkreis, der die Spannung UA erzeugt, das Clamping aktiviert. Ist also keine Spannung über R₃ vorhanden, sind die beiden Transistoren Q₃ und Q₄ ausgeschaltet und stellen eine hochohmige Verbindung zwischen den Basen B von Q₁, Q₂ und der Masse GND dar. Steigt nun die Spannung U_{GE}, so beginnt ein Strom ab einer Spannung von ca. der Summe der Basis-Emitterspannungen von Q1 und Q2 durch R₁ in die Basis B von Q₂ zu fließen. Die Transistoren Q₁ und Q₂ schalten ein und beginnen somit die Ladung am Gate G des IGBT 2 nach Masse GND abzuführen, d.h. die Spannung am Gate G des IGBT zu klemmen. Der Schaltkreis wirkt wie ein niederohmiger Widerstand mit einer Spannungsquelle der Höhe der Summe der Basis-Emitterspannungen von Q1 und Q2 in Reihe.

Der Kondensator C₁ ist ein Beschleunigungskondensator und verstärkt bei schneller Änderung der Spannung am Gate G des IGBT 2 den Basisstrom in die Basis B von Q₂.

Zur Deaktivierung des Clampings muss eine Steuerspannung U_{A} angelegt werden, so dass die Einschaltschwellen der Transistoren Q₃ und Q₄ sicher überschritten werden. Die Transistoren Q₃, Q₄, im Beispiel FETs, werden eingeschaltet. Somit werden die Basen B von Q₁ und Q₂ auf Massepotential GND gezogen. Die Transistoren Q₁ und Q₂ sind nun sicher ausgeschaltet. Es ist notwendig, dass beide Basen B von Q₁ und Q₂ gleichzeitig auf Masse GND gezogen werden um ein schnelles Ausschalten und damit Deaktivieren des Clamping-Schaltkreises, also der Bypassschaltung 13, zu gewährleisten.

Im so entstehenden deaktivierten Zustand der Clampingschaltung 10 wirkt nur noch der Widerstand R₁, der im Beispiel mehrere kQ groß ist, auf das Gate G des IGBT 2. Die im Betrieb entstehende Verlustleistung ist somit vernachlässigbar.

Die Diode D₁ entkoppelt die restliche Clampingschaltung 10 vom Gate G des IGBT 2, so dass keine negative Spannung bei abgeschaltetem IGBT 2 an den Kollektoren C von Q₁ und Q₂ anliegt.

## Patentansprüche

1. Clampingschaltung (10) für einen auf ein Bezugspotential (GND) bezogenen Schalteingang (8) eines Leistungshalbleiterschalters (2), mit einem mit dem Schalteingang (8) verbindbaren Knoten (16) und einem vom Knoten (16) zum Bezugspotential (GND) führenden Widerstandselement (11) mit einem Aktivierungseingang (12), das im nicht aktivierten Zustand einen ersten Widerstandswert (R_{GE1}) aufweist und im aktivierten Zustand einen zweiten, höheren Widerstandswert (R_{GE2}) aufweist.

2. Clampingschaltung (10) nach Anspruch 1, bei dem das Widerstandelement (11) einen am Knoten (16) angeschlossenen und zum Bezugspotential (GND) führenden ohmschen Widerstand (R1) im Bereich des zweiten Widerstandwertes (R_{GE2}), und eine den ersten Widerstandswert (R_{GE1}) aufweisende, im nicht aktivierten Zustand leitende, und im aktivierten Zustand gesperrte Bypassschaltung (13) für den Widerstand (R1) enthält.

3. Clampingschaltung (10) nach Anspruch 2, bei dem die Bypassschaltung (13) enthält:
- mindestens einen mit seinem Kollektor (C) am Knoten (16) und mit seiner Basis (13) am dem Knoten (16) abgewandten Ende (18) des Widerstands (R1) angeschlossenen ersten Transistor (Q1), dessen Emitter (E) zum Bezugspotential (GND) führt,
- einen zwischen Widerstand (R1) und Bezugspotential (GND) angeordneten, im nicht aktivierten Zustand geöffneten, durch den Aktivierungseingang (12) schließbaren Schalter (15).

4. Clampingschaltung (10) nach Anspruch 3, bei der der Schalter (15) einen vom Aktivierungseingang (12) angesteuerten zweiten Transistor (Q3) enthält.

5. Clampingschaltung (10) nach Anspruch 3 oder 4, bei der der erste Transistor (Q1) Teil einer Transistorkaskade (17) nach Art eines Darlington-Transistors ist.

6. Clampingschaltung (10) nach Anspruch 5, bei der jedem Transistor (Q1, Q2) der Transistordekade (17) ein eigener, gleichschaltender Schalter (Q3, Q4) zugeordnet ist.

7. Clampingschaltung (10) nach einem der Ansprüche 3 bis 5, mit einem dem Widerstand (R1) parallel geschalteten Kondensator (C₁).

8. Clampingschaltung (10) nach einem der vorhergehenden Ansprüche, bei der der Knoten (16) mit dem Eingang (8) über eine Diode (D₁) verbindbar ist.
